# EUROPEAN PATENT APPLICATION

(11) **EP 1 881 024 A1**
(43) Date of publication of application: **23.01.2008**
(21) Application number: 06076435.4
(22) Date of filing: 18.07.2006
(51) Int. Cl.: C08K 5/00, F03G 7/00

(54) **Use of a plasticizer in an electroactive polymer composition**

(71) Applicant: Nederlandse Organisatie voor toegepast- natuurwetenschappelijk onderzoek TNO, 2628 VK The Hague (NL)
(72) Inventor: Boersma, Arjen, 5237 KL's-Hertogenbosch (NL)
(74) Representative: van Loon, C.J.J.

(57) **Abstract**

The invention relates to the use of a plasticizer in a polymer composition for providing electroactivity to the composition or increasing the electroactivity of the composition. The invention further relates to an (an article) comprising an actuator for converting between mechanical and electrical energy comprising
- at least two electrodes; and
- an electroactive polymer composition, comprising a polar polymer and a polar plasticizer.

## Description

The invention relates to the use of a plasticizer to impart or improve the electroactivity of a polymer composition. The invention further relates to an electroactive polymer composition comprising a plasticizer and to an actuator comprising a plasticizer. Further, the invention relates to an article comprising such an actuator.

Polymers capable of converting electrical energy into mechanical energy and/or of converting mechanical energy into electrical energy (referred to herein as being electroactive) have been reported to be potentially interesting alternatives to common actuator technologies, such as electromagnetic motors, piezoelectric ceramics and solenoids.

US application 2004/0263028 relates to a transducer comprising a electroactive polymer selected from polymers based on homopolymerisable monoethylenically unsaturated monomers, thermoplastic elastomers and silicone based polymers. The actually described polymers tend to be relatively stiff (high E-modulus), are based on apolar mononomers and/or have a relatively low electrical dielectric constant (ε). This puts limits to their processibility and/or their electroactive properties. Optionally a (relatively hydrophobic) plasticizer may be included such as hydrocarbon oils or greases, silicone oils or greases or non-ionic surfactants. It is not mentioned to use a (polar) plasticizer to make a polymer composition electroactive or to increase electroactivity of a polymer composition.

It is an object of the invention to provide a new way of modifying a polymer (composition) such that it becomes electroactive, or such that its electroactivity is increased.

It is an object of the invention to provide a novel electroactive polymer composition, in particular such composition which may be used in an actuator to convert electrical energy into mechanical energy and/or to convert mechanical energy into electrical energy.

It is in particular an object of the invention to provide a novel actuator comprising a polymer composition that has good processing properties.

It is a further object to provide a novel actuator comprising a polymer composition that can be deformed to a high extent in order to generate electrical energy.

Other objects which may be solved in accordance with the invention are indicated herein below.

It has now been found that one or more of the objects are solved by using a plasticizer for a specific reason.

Accordingly, the invention relates to the use of a plasticizer in a polymer composition for making the composition electroactive or for increasing the electroactivity of the composition.

Figure 1 shows the absolute vertical deformation upon electric activitation of two commercially available membranes and two membranes of the present invention.

Figure 2 shows the relative vertical deformation upon electric activitation of two commercially available membranes and two membranes of the present invention.

Within the context of the present description and claims electroactivity is provided/increased if the mechanical deformation of the composition is increased upon subjecting the composition to a specific electric field strength and/or the change in the electric field strength is increased upon subjecting the composition to a specific mechanical deformation, compared to the same composition (or the pure polymer) in the absence of said plasticizer. The electroactive composition may in particular be used to generate an electric current by applying an electric potential over an article comprising the polymer and subsequently mechanically deforming the article comprising the polymer composition.

In particular suitable is a polar plasticizer, especially in a polymer composition comprising a polar polymer.

A plasticizer is in particular considered polar in case the polar component of the Hansen solubility parameter is higher than 10, preferably higher than 15.

A polymer is in general considered polar if it allows a surface made of such polymer to be wetted with water, forming a water film or coating on the surface. A polar polymer usually has a high surface tension and/or a high dielectric constant.

The surface tension is in particular considered high if it is at least 35 dynes/cm, more in particular at least 39 dynes/cm.

The dielectric constant of a polymer is in particular considered high if it is at least 8, more in particular at least 10.

For instance the polymer may be selected from Polyvinylidene Fluorides, Polyepichlorohydrins, polysaccharides and derivatives thereof (in particular Amyloses, Amylopectins, Celluloses), Poly Vinyl Alcohols, Poly Vinyl Chlorides, Polysulfones, Polycarbonates, Polyesters (in particular Polyethylene Terephthalates), Proteins (such as Casein), Polyacrylonitriles, polyalkylene oxides (in particular polyethylene oxide), polyamides (in particular Poly Hexamethylene Adipamide (Nylon 6/6)), aromatic urethanes, aromatic urethane acrylates, (alkyl)acrylates, polyvinylpyrrolidones and polyethyloxazolines, including copolymers and blends of these polymers. Other suitable and preferred polymers are identified herein below.

It has been found that by using a plasticizer in accordance with the invention not only flexibility of the polymer composition may be improved (in particular in case the polymer is relatively stiff), but also the electroactivity. It is contemplated that the plasticizer in particular has an advantageous effect on the dielectric constant (ε).

In accordance with the invention, the plasticizer may be added to the polymer (composition) in a manner known in the art, in particular by mixing the plasticizer with a solution, a dispersion, a monomer mixture or a melt comprising the polymer and optionally other components. From the mixture the polymer composition (which is usually solid at room temperature) may then be formed by removing the solvent (e.g. by evaporation), separating the dispersed composition from the continuous phase, curing the monomers, respectively allow the melt to solidify.

The concentration wherein the plasticizer (or plasticizers) may be used in accordance with the invention can be chosen within a wide range, as long as it is effective in imparting or increasing electroactivity. Usually the concentration is chosen such that the resultant polymer composition has an ε of at least 10, preferably of at least 15, more preferably of more than 20, even more preferably of at least 25. The upper limit is not particularly critical. In principle it may be 100 or more. For practical reasons ε of the composition may be 100 or less, more in particular 75 or less, or 50 or less. As used herein ε is the value as determinable by dielectric relaxation spectroscopy at room temperature (23 °C), 50 % relative humidity (RH) and a frequency of 20 Hz. The E-modulus of the resulting polymer compostion is preferably 10 MPa or less, more preferably 2 MPa or less.

Usually, the plasticizer concentration is at least about 5 wt. % of the composition. Usually the concentration is 80 wt. % or less. In particular, the plasticizer concentration may be chosen in the range of 10 to 80 wt. % of the composition, preferably 20 to 70 wt. %.

The plasticizer is preferably a liquid at 20 °C, in order to avoid crystallisation in the composition.

Preferably a plasticizer used according to the invention has a high dielectric constant (ε). Preferably ε is at least 20, more preferably at least 25, even more preferably at least 30. The upper limit is not particularly critical. For instance ε of the plasticizer may be up to 100 or more than 100.

Suitable plasticizers include mono and polyfunctional alcohol (such as glycerol, propanediol, butanediol, ethylene glycol ethanol, sorbitol), anhydrides (such as citraconic and maleic anhydryde), aldehydes and ketones (such as furfural, acetyl acetone), sulphur containing plasticizers (such as dimethyl sulphate, dimethylsulfoxide), amides of carboxylic acids (such as (alkyl)-acetamide, (alkyl)-formamide, (alkyl)-propanamide) organic nitriles (such as acetonitrile, benzonitrile, glycolic nitrile, lactonitrile, propionitrile, malonic nitrile, succinonitrile), amines (such as ethanolamine, di/tri ethanolamine), cyano carboxylic acids (such as cyano acetic acid, alkyl cyano carboxylates (such as ethyl cyano acetate, carboxylic acids (such as formic acid, tartaric acid), aromatic compounds comprising a nitro-group (such as o-nitrotoluene, o-nitroaniline, p-nitroaniline, methyl nitrobenzoate, nitro benzene, nitrophenyl-alcohols, nitroanisole, 1-nitrophenyloctylether, 2-fluoro-2 nitrodiphenyl ether, nitrophenylethanol) and carbonates (such as ethylene carbonate, propylene carbonate, butylene carbonate).

A preferred plasticizer used in accordance with the invention is represented by the formula Yₙ-Ar-Xₘ, wherein
- each Y independently represents a polar moiety;
- Ar represents an aromatic moiety;
- each X independently represents a moiety comprising an ester, ether, thioester or thioether link ; n (i.e. the number of moieties Y bound to Ar) is an integer having a value of at least 1, preferably of 1 or 2; and m (i.e. the number of moieties X bound to Ar) is at least 1.
   The upper limit of n and m is determined by the number of bonds that can be made between the carbons in Ar and the Y respectively X moieties. For instance in case Ar is a 6-membered aromatic carbon ring, the sum of n+m is at most 6.

X may further comprise an aliphatic and/or aromatic group, separated from the aromatic group Ar via-said link. In particular X may also comprise a moiety Y, for instance an Ar-Yₙ.

The compound represented by the formula Yₙ-Ar-Xₘ preferably comprises at least one moiety Y selected from the group consisting of -CN, -NO₂ , -COOH, -CHO, -COOR, -CH=C(CN)₂, -(CO)(NH₂)-, -(CO)(NHR) and -(CO)(NRR), wherein each R represents the same or a different substituted or unsubstituted hydrocarbon group (in particular a substituted or unsubstituted C1-C6 alkyl). X is a moiety comprising said link and an aromatic group or aliphatic group and/or a moiety selected from the group consisting of -NH₂, -F, -Cl, -Br, -I -OCH₃, -NHR and -NRR.

Good results have in particular been achieved with a plasticizer represented by the formula Yₙ-Ar-Xₘ, wherein Yₙ is a nitro group and X comprises an ether and a fluor substituted aromatic or an aliphatic moiety. Highly preferred plasticizers include nitrophenyloctylether (ε = 30) and 2-fluoro-2 nitrodiphenyl ether (ε = 50).

Another preferred plasticiser is a carbonate containing compound, in particular an alkylene carbonate, such as ethylene carbonate (ε = 90), propylene carbonate (ε = 66) or a blend thereof.

Preferably, a plasticizer is used in accordance with the invention in a polymer composition comprising at least one polymer selected from the group consisting of polyvinyl chlorides (PVC), polysaccharides, aromatic urethanes, aromatic urethane acrylates, (alkyl)acrylates (such as polymethylmethacrylate), acrylonitrile polymers (PAN, SAN), polysaccharide derivatives (such as starch, starch acetate, cellulose (tri)acetate), polyethers (such as polyethylene oxide), polyvinylpyrrolidone, polyethyloxazoline, polyvinylidene fluoride and silicone polymers, including copolymers thereof.

Advantageously, the polysaccharide may be derivatised, in particular by esterification, more in particular by esterification with acetate or phthalate.

Particularly preferred are PVC, (derivatised) starch, (derivatised) cellulose, polyacrylonitrile, polyvinylidene fluoride, polyethylene oxide and copolymers of aromatic urethanes and (alkyl)acrylates. Of the cellulose polymers particularly good results have been realised with cellulose acetate and cellulose phthalate.

In an advantageous embodiment, the polymer composition, wherein the plasticizer is used, comprises an electroactive polymer, in particular an electroactive polymer having a dielectric constant of at least 5, preferably of at least 7.5, more preferably of between 10 and 100. It is contemplated by the inventors that the dielectric constant may be increased by enhancing the mobility of the chains, e.g. by the addition of a plasticizer.

Particularly preferred is an electroactive polymer, comprising aromatic moieties in the chain and flexible moieties in the chain, the polymer further optionally comprising side groups bound to the chain, which side groups are selected from the group consisting of polar side groups and side groups comprising an aromatic moiety.

Flexible moieties may in particular be selected from (cyclo) aliphatic ether moieties, (cyclo) aliphatic ester moieties, (cyclo) aliphatic thioether moieties and (cyclo) aliphatic thioester moieties. A preferred flexible moiety is represented by the general formula -Rₓ-Fl-R_{y}- wherein Fl represents an ether, ester, thioether or thioester link and Rₓ and R_{y} represent the same or alkylene or cycloalkylene may be substituted or unsubstituted.

The aromatic moieties in the chain and/or in the side groups of the electroactive polymer preferably have 6-20 carbon atoms. The aromatic moieties typically comprise one or more aromatic rings. Particularly suitable are optionally substituted phenyl groups, optionally substituted anthracene groups and optionally substituted naphthalene groups. An aromatic moiety comprising a phenyl group is particularly preferred.

The inventors have come to the insight that the provision of a polymer with side groups, in particular such that the polymer becomes a branched polymer, is advantageous with respect to its usefulness as an electroactive polymer in an actuator. In particular the inventors contemplated that the side groups contribute to improving the mechanical properties (lower stiffness; reduced Tg) and/or increasing ε.

Preferred polar moieties as (part of) the side groups include moieties selected from the group consisting of -OH, -CN, -NH₂ , -NO₂ , aryloxy (such as -phenoxy), -phenyl, halogens (such as -Cl, -F, -I, -Br), -(CO)(NH₂)-, -COOH, -(CO)(NHR)-, -(CO)(NRR)- NHR and NRR. In these moieties each R independently represents an alkyl which may be substituted or unsubstituted, in particular a substituted or unsubstituted C1-C6 alkyl.

The presence of a polar side group is in particular considered advantageous with respect to increasing the dielectric constant ε. It usually also has a Tg lowering effect.

It is highly preferred that the electroactive polymer comprises both side groups with aromatic moieties and side groups with polar moieties, side groups with both aromatic moieties and polar moieties, or a combination thereof. It is particularly preferred that the electroactive polymer in the electroactive composition is a polyurethane-(alkyl)acrylate copolymer, wherein at least part of the monomeric units are based on a monomer selected from the group consisting of monomers represented by formula I and monomers represented by formula II 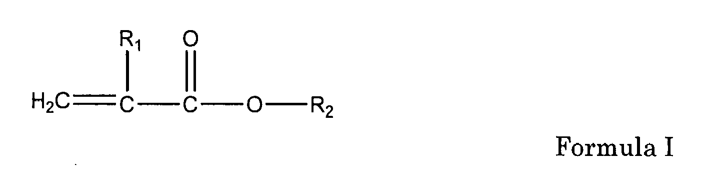 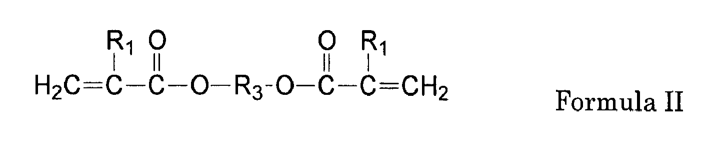 wherein each R₁ is independently hydrogen, an optionally substituted alkyl (in particular methyl) or a polar moiety
wherein R₂ is a polar moiety, an aromatic moiety (as defined above, and preferably an aromatic moiety containing a phenyl group) an optionally substituted alkyl or hydrogen
provided that at least one or R₁ and R₂ is a polar moiety or an aromatic moiety.

R₃ comprises at least one aromatic moiety based on an aromatic diisocyanate, in particular on an aromatic diisocyanate selected from the group consisting of toluenediisocyanate (TDI) and methylene diphenyl isocyanate (MDI).

Such a polymer has been found to have a suitable E-modulus and ε such that it may be used in an actuator. Such a polymer has been found favourable in that it can be processed easily. Advantageously such polymer may be flowable at room temperature, which makes it easy to shape it into any desired form and thickness by diverse techniques.

Preferably at least part of the aromatic moieties in the chain are based on an aromatic diisocyanate, in particular on an aromatic diisocyanate selected from the group consisting of toluenediisocyanate (TDI) and methylene diphenyl isocyanate (MDI).

The polymer concentration of the electroactive polymer composition is preferably such that the composition is an (elastomeric) solid at room temperature. Usually the concentration is in the range of 30 to 99 wt. % of the composition, preferably in the range of 40 to 90 wt. % of the composition.

For improving mechanical stability, the polymer may be crosslinked. For improving strength and/or tear resistance the number of cross-links is preferably at least 0.0005 mol cross-links per 1000 g, more preferably at least 0.001 cross-links per 1000 g. In view of maintaining an advantageously low E-modulus, the amount of cross-links is preferably less than 0.4 mol cross-links per 1000 g, more preferably less than 0.2 mol cross-links per 1000 g.

The polymer (used) according to the invention preferably has a weight average molecular weight (Mw) of at least 5 000 g/mol. For improved strength (such as resistance against tearing) Mw is preferably at least 20 000 g/mol. For favourable deformation properties, Mw is preferably 200 000 g/mol or less, in particular 150 000 g/mol or less. The Mw as used herein is the Mw, as determinable by GPC using polystyrene standards, of the polymer in a noncross-linked state.

The electroactive polymer composition wherein the plasticizer is used may further comprise one or more additives, such as conventional additives for (electroactive) polymer compositions and/or electroactivity increasing additives.

In particular when the composition is to be used in an actuator, the additives (if any) are usually chosen in an amount such that the E-modulus is less than 20 MPa, preferably 0.1-10 MPa and/or ε is at least 10, preferably more than 15, in particular 25-100, and/or Tg is at most 0°C, preferably in the range of -100 to -20 °C. The E-modulus as used herein is the value as determinable by a tensile tester at room temperature (23 °C), 50% RH and a tensile speed of 5 mm/min. The Tg as used herein is the Tg as determinable by differential scanning calorimetry (DSC) at a heating rate of 10 °C/min.

Such additives may generally be used in a total amount in the range of 0.1 to 40 wt.%.

Preferred additives include carbon nanotubes having a high ε, (ceramic) particles having a high ε and organic polarisable compounds having a high ε (in particular having a higher ε than the polymer, more in particular an ε of at least 50). Examples of such particles include BaTiO₃, lead zirconate titanate (PZT) and other ferroelectric ceramic particles. Examples of polarisable compounds include aromatic conjugated organic molecules, such as phthalocyanine derivatives and porphyrin derivatives.

Preferred organic polarisable compounds are represented by the formula

P₁-Ar₁-U-Ar₂-P₂

Herein P₁ is an electron donating moiety, preferably selected from the group consisting of -OH, -NH₂, -NROH -NHR, -NRR, -OR, -O(CO)R, -NH(CO)R, aryloxy , -phenyl, wherein each R represents the same or a different substituted or unsubstituted hydrocarbon group, in particular the same or a different substituted or unsubstituted C1-C6 alkyl. More preferably P₁ is selected from -NH₂ , NROH -NHR, -NRR, and -NH(CO)R .
Herein P₂ is an electron accepting moiety preferably selected from the group consisting of -CN, -NO₂, -SO₃H, -CF₃, halogens (such as -F, -Cl, -Br, -I) -COOH, -COOR, -(CO)R wherein each R represents the same or a different substituted or unsubstituted hydrocarbon group, in particular the same or a different substituted or unsubstituted C1-C6 alkyl. Most preferably P₂ represents -NO₂.
Ar₁ and Ar₂ are aromatic moieties, preferably from phenyl, anthracene and naphthalene comprising moieties, more preferably from phenyl comprising moieties.
U represents a moiety comprising a double bound, preferably comprising a C=C or N=N bond.

Particularly suitable examples of polarisable compounds include Disperse Red 1 and Disperse Orange 3.

Such a compound may be used in a polymer composition to improve its electroactive properties, in particular it may be used to increase ε.
If present, the concentration is preferably 0.1 to 30 wt.% of the total composition.

The invention further relates to an electroactive polymer composition comprising (a) at least one plasticizer, represented by the formula Yₙ-Ar-Xₘ, wherein Y, Ar, X, n and m are as defined above and (b) at least one polymer.

In a composition of the invention, analogous preferences apply for the plasticizer(s), the polymer(s), the additives (such as ε increasing additives, organic polarisable compounds), the concentration of the components, and/or the physical/chemical properties (Tg, ε, E-modulus) of the polymer/plasticizer/composition as described above.

Thus, in particular the polymer is preferably selected from the group consisting of polyvinyl chlorides (PVC), polysaccharides, aromatic urethanes, aromatic urethane acrylates, (alkyl)acrylates (such as polymethylmethacrylate), acrylonitrile polymers (PAN, SAN), polysaccharide derivatives (such as starch, starch acetate, cellulose (tri)acetate), polyethers (such as polyethylene oxide), polyvinylpyrrolidone, polyethyloxazoline, polyvinylidene fluoride and polymers comprising aromatic moieties in the chain and flexible moieties in the chain, the polymer further comprising side groups bound to the chain, which side groups are selected from the group consisting of polar side groups and side groups comprising an aromatic moieties (such as those wherein at least part of (alkyl)acrylate units are based on a monomer represented by formula I and/or formula II, as identified above), including copolymers of any of these polymers.

Thus, the E-modulus of a composition of the invention is usually less than 20 MPa, preferably 0.1-10 MPa. ε is usually at least 10, preferably more than 15, in particular 25-100. Tg is usually at most 0°C, preferably in the range of -100 to -20 °C.

In particular good results have been achieved with an electroactive polymer composition comprising an aromatic polyurethane acrylate and a plasticizer containing carbonate groups, such as ethylene carbonate and/or propylene carbonate.

Further preferred is an electroactive polymer composition comprising PVC and an aromatic compound comprising a nitro group, especially a nitrophenyl compound. In particular, good results have been achieved with a nitrophenyl ether such as a nitrophenylalkyl ether (1-nitrophenyloctyl ether) or a halogenonitrodiphenyl ether (2-fluoro-2 nitrodiphenyl ether).

The plasticizer, respectively the electroactive polymer composition may advantageously be used in an actuator. Accordingly, the invention further relates to an actuator for converting between mechanical and electrical energy comprising
- at least two electrodes; and
- an electroactive polymer composition, comprising a polar polymer and a polar plasticizer.

In an actuator of the invention, analogous preferences apply for the plasticizer(s), the polymer(s), the additives (such as ε increasing additives, organic polarisable compounds), the concentration of the components, and/or the physical/chemical properties (Tg, ε, E-modulus) of the polymer/plasticizer/composition as described above.

The design of the actuator may be based on any actuator known in the art, in particular any such actuator comprising an electroactive polymer, e.g. as shown in US application 2004/0263028, US application 2004/232807, WO 03/056287, US application 2003/006669, WO 05/027161 or EP-A 1 512 215. The contents of these publications, in particular with respect to the design of the actuators described therein, more in particular with respect to the design of the actuators shown in the Figures and the description of the Figures in these publications are incorporated herein by reference.

The actuator may be manufactured, making use of techniques, which are known per se. In an embodiment the electroactive polymer (which may be in a polymer composition) is shaped into a desired form, *e.g.* a film, a coating, a sheet or a 3D shape. Advantageously the polymer (composition) is in a flowable form, such as a melt, a solution, a fluid dispersion or a liquid mixture. This provides a high level of flexibility with respect to design. Suitable shaping techniques include spraying, casting, moulding, spin coating, dipping, extruding, printing, rapid manufacturing (3-D modelling, rapid prototyping).

In case the polymer is flowable, it is allowed to harden after shaping (such that it retains it shape without being supported), in particular to solidify.

After shaping, usually the at least two electrodes are applied to the shaped polymer such that they are in electrically conductive contact with the polymer. Suitable application techniques are known in the art and can routinely be chosen based upon the material of choice for the electrodes and include spraying, casting, moulding, spin coating, dipping, printing, rapid manufacturing (3-D modelling, rapid prototyping). The electrodes may be made of any electrically conductive material, in particular any material suitable for use in polymeric conductive devices. Such materials are known in the art and include materials selected from the group consisting of electrically conductive polymers and compositions comprising at least one of electrically conductive fillers, electrically conductive greases and electrically conductive particles. Such materials can also include electrolyte containing polymers and gels, in which the electrolyte can be a lithium salt, for instance selected from the group consisting of lithium trifluoromethanesulfonate (LiCF₃SO₃), LiClO₄ and LiBF₄.

The invention further relates to an article comprising a polymer composition, and in particular an actuator according to the invention.

In particular the article may be selected from the group consisting of parts for a motor vehicle (adjustable mirrors, pumps, injectors, windscreen wipers, seats), sports articles (skis, helmets, knee protectors, elbow protectors, shinbone protectors, protectors for other body parts), textiles, shoes, healthcare articles (rehabilitation articles, surgical devices, implantable valves, pacemakers, cathethers {guidable}, supportive clothing, artificial muscles, microsystems (moveable parts in electronic equipment such as DVD/CD players, disk drives, microlocks, microswitches, cameras (focus, zoom), speakers, microphones, anti-vibration materials), pumps, valves, drives, antitheft tags, packings, gaskets, devices for inducing peristaltic movement.

The actuator (respectively polymer or polymer composition) of the invention may in particular be used to convert mechanical energy into electrical energy and/or to convert electrical energy into mechanical energy.

In an embodiment a polymer, composition or an actuator according to the invention is used to make the roughness of a surface adjustable, as a massaging facility, to influence the aerodynamic behaviour of a surface, to make insulating properties of an article adjustable, to make stretchability of an article adjustable or to improve support, comfort or protective properties of an article.

The invention will now be illustrated by the following examples.

### Example 1

6 grams of a 27.5 wt. % cellulose acetate (FLUKA, Mw approx. 37 000 g/mol) solution in acetone was mixed with 0.6 grams of glycerol. The mixture was heated to 60 °C, filtered and subjected to sonificaton for 5 min. Thereafter a film was made on release paper with a 750 µm Bird film applicator.

The solvent was allowed to evaporate. The resultant film was flexible and elastic.

### Example 2

50 grams of a 4 wt. % native potato starch (Avebe) solution in water was mixed with 3 grams of glycerol. The mixture was heated to 60 °C, filtered and subjected to sonicaton for 5 min. Thereafter a number of films were made on release paper with a 1000 µm Bird film applicator.

The solvent was allowed to evaporate. The resultant film was flexible and elastic. Depending upon the residual water content, ε of the film was found to be in the range of 70-90.

### Example 3

A 22.49 wt. % PVC solution in tetrahydrofuran (THF) was mixed overnight with dibuthylphtalate, 1-nitrophenyl octyl ether or 2-fluoro 2-nitrodiphenyl ether. The mixture was heated to 60 °C and subjected to sonicaton for 5 min.. The resultant solution was filtered and a film was made on a glass plate using a Bird film applicator. The conditions/properties were as shown in Table 1:

**Table 1**

| # | plasticizer | wt. % in film | thickness (µm) | εᵣ | V_{break} (v/µm) | E (MPa) |
|---|---|---|---|---|---|---|
| 3A^{*} | none | 0 | 100 | 3.7 | 65 | 2000 |
| 3B | dibuthylphtalate | 40 | 140 | 5.2 | | 9.0 |
| 3C | dibuthylphtalate | 50 | 70 | 7.3 | 56 | 8.1 |
| 3D | dibuthylphtalate | 60 | 75 | 8.4 | | 3.9 |
| 3E | dibuthylphtalate | 70 | 80 | 8.8 | | 3.0 |
| 3F | 2-fluoro 2-nitrodiphenyl ether | 50 | 61 | 17.5 | 45 | 7.5 |
| 3G | 1-nitrophenyl octyl ether | 50 | 61 | 12.5 | 47 | 6.4 |

| | | | | | | |
|---|---|---|---|---|---|---|
| * reference film consisting of the PVC | | | | | | |

The examples show that dibuthylphtalate (ε=6.4) has only a minor increasing effect on ε. The most effect can be attributed to the increased mobility of the PVC chains.

In the presence of 1-nitrophenyl octyl ether respectively 2-fluoro 2-nitro-diphenyl ether properties the film's dielectric constant is increased to above 10 and the E-modulus is more decreased than with dibuthylphtalate (at the same concentration)

### Example 4

Blends of the aromatic urethane acrylates Actilane 170™ and Actilane 410™ were mixed with the plasticizers ethylene carbonate (EC) and propylene carbonate (PC). The blends were cured using the photoinitiator Irgacure 2020. The amount of plasticiser (EC:PC = 6:4) was varied between 60 and 90 weight% {?} . Table 2 shows the composition of the resulting films and some important characteristics.

**Table 2**

| Actilane 170 | Actilane 410 | EC | PC | Irgacure 2020 | E (MPa) | εᵣ (100kHz) |
|---|---|---|---|---|---|---|
| 39.2 | - | 35.3 | 23.5 | 2 | 0.56 | 23 |
| 19.6 | 19.6 | 35.3 | 23.5 | 2 | 0.19 | 29 |
| 29.4 | - | 41.2 | 27.4 | 2 | 0.35 | 31 |
| 14.7 | 14.7 | 41.2 | 27.4 | 2 | 0.17 | 41 |
| 19.6 | - | 47.0 | 31.4 | 2 | 0.15 | 62 |

The modulus of elasticity decreases significantly upon the addition of plasticizer. Furthermore the dielectric constant at 100 kHz is increased by the addition thereof. The mixture of Actilane 170/410 shows a lower modulus, because of the higher flexibility of the polymer chains.

### Example 5

The efficiency of the electroactive films was assessed by measuring the deformation of a thin film upon electric activation. The film was slightly stretched and mounted in a frame, thus forming a membrane. Then, a conducting electrode was applied (conducting silicon grease). The film was loaded with a small weight (preload), after which the deformation of the membrane is measured. The electroactivity was measured by applying a voltage over the film and measuring the additional deformation of the film. The deformation of the film depends on both the preload and on the voltage applied.

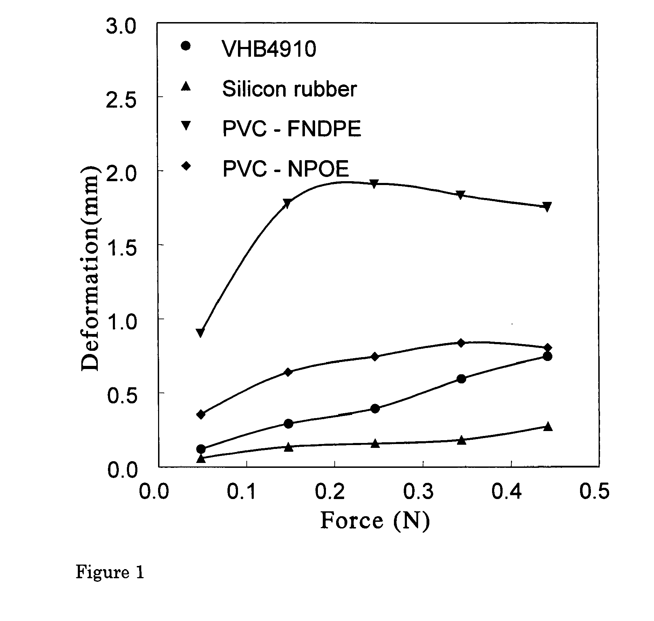

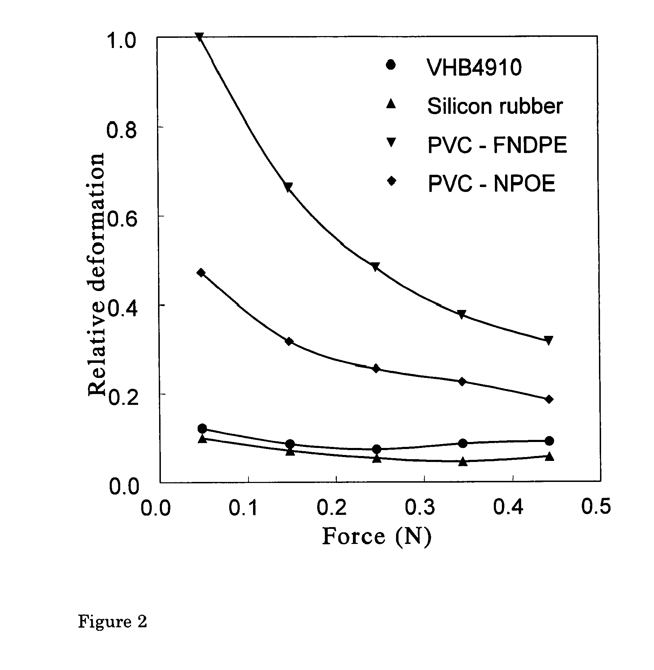

Figures 1 and 2 show the absolute respectively relative vertical deformation of the membrane upon electric activation. The preload increased from 0.05 to 0.5 N. The films shown in the figures are a commercially available VHB4910 film (stretched, 50 µm thick), a commercially available silicon rubber (Silastic, 75 µm thick), a 61 µm thick PVC film plasticized with 50 weight % 2-fluoro-2-nitrodiphenyl ether (FNDPE) according to the invention and a 61 µm thick PVC film plasticized with 50 weight % nitrophenyloctyl ether (NPOE) according to the inventio. The relative deformation is defined as the additional deformation by the electric field divided by the deformation caused by the preload.

The figures show that the plasticized PVC samples have a far better electroactivity than the commercially available acrylic (VHB4910) or silicon films.

## Claims

1. Use of a plasticizer in a polymer composition for providing electroactivity to the composition or increasing the electroactivity of the composition.

2. Use according to claim 1, wherein the plasticizer is a polar plasticizer and the polymer is a polar polymer.

3. Use according to claim 1 or 2, wherein the plasticizer is a compound represented by the formula Yₙ-Ar-Xₘ, wherein
- each Y independently represents a polar moiety;
- Ar represents an aromatic moiety;
- each X independently represents a moiety comprising an ester, ether, thioester or thioether link
n is the number of moieties Y bound to Ar and is an integer of at least 1; and m is the number of moieties X bound to Ar and is an integer of at least 1.

4. Use according to claim 3, wherein the compound represented by the formula Yₙ-Ar-Xₘ comprises at least one moiety Y selected from the group consisting of -OH, -CN, -NH₂, -NO₂, aryloxy , -phenyl, halogens, -COOH, NHR, NRR, -(CO)(NH₂)-, -(CO)(NHR) and -(CO)(NRR), wherein each R represents the same or a different substituted or unsubstituted hydrocarbon group, and preferably at least one moiety Y is selected from the group consisting of -NO₂, -F, -Cl, -Br, -I and -CN.

5. Use according to claim 1 or 2 wherein the plasticizer is an alkylene carbonate.

6. Use according to any one of the preceding claims wherein the plasticizer is a liquid at 20 °C.

7. Use according to any one of the preceding claims, wherein the plasticizer has a dielectric constant (ε) of at least 20, in particular of 25-100.

8. Use according to any one of the preceding claims, comprising at least one polymer selected from the group consisting polyvinyl chlorides, polysaccharides, aromatic urethanes, aromatic urethane acrylates, (alkyl)acrylates, acrylonitrile polymers, polysaccharide derivatives (such as starch acetate, cellulose (tri)acetate), polyethers, polyvinylpyrrolidone, polyethyloxazoline, polyvinylidene fluoride, and polymers comprising aromatic moieties in the chain and flexible moieties in the chain, the polymer further comprising side groups bound to the chain, which side groups are selected from the group consisting of polar side groups and side groups comprising an aromatic moieties, including copolymers of any of these polymers.

9. An actuator for converting between mechanical and electrical energy comprising
- at least two electrodes; and
- an electroactive polymer composition, comprising a polar polymer and a polar plasticizer.

10. An actuator according to claim 9, wherein the plasticizer is as defined in any one of the claims 3-7.

11. An actuator according to claim 9 or 10, wherein the polymer composition comprises at least one polymer selected from the group consisting polyvinyl chlorides, polysaccharides, aromatic urethanes, aromatic urethane acrylates, (alkyl)acrylates, acrylonitrile polymers, polysaccharide derivatives (such as starch acetate, cellulose (tri)acetate), polyethers, polyvinylpyrrolidone, polyethyloxazoline, polyvinylidene fluoride, and polymers comprising aromatic moieties in the chain and flexible moieties in the chain, the polymer further comprising side groups bound to the chain, which side groups are selected from the group consisting of polar side groups and side groups comprising an aromatic moieties, including copolymers of any of these polymers, preferably a polymer selected from the group consisting of polyvinyl chlorides, polysaccharides, aromatic urethane-(alkyl)acrylate polymers, including copolymers thereof.

12. An electroactive polymer composition comprising (a) at least one plasticizer, represented by the formula Yₙ-Ar-Xₘ, wherein Y, Ar, X, n and m are as defined in any one of the claims 3-5, and (b) at least one polymer selected from the group consisting of polyvinyl chlorides, polysaccharides, aromatic urethanes, aromatic urethane acrylates, (alkyl)acrylates, acrylonitrile polymers, polysaccharide derivatives (such as starch acetate, cellulose (tri)acetate), polyethers, polyvinylpyrrolidone, polyethyloxazoline, and polyvinylidene fluoride, including copolymers of any of these polymers, preferably a polymer selected from the group consisting of polyvinyl chlorides, polysaccharides, aromatic urethane-(alkyl)acrylate polymers, including copolymers thereof.

13. An electroactive polymer composition comprising (a) at least one plasticizer selected from the group consisting of alkylene carbonates and plasticizers represented by the formula Yₙ-Ar-Xₘ, wherein Y, Ar, X, n and m are as defined in any one of the claims 3-4, and (b) at least one polymer comprising aromatic moieties in the chain and flexible moieties in the chain, the polymer further comprising side groups bound to the chain, which side groups are selected from the group consisting of polar side groups and side groups comprising an aromatic moiety.

14. Electroactive polymer composition according to claim 12 or 13, comprising at least one plasticizer selected from the group consisting of aromatic compounds comprising a nitro-group, preferably at least one plasticizer selected from nitrophenyl ethanol, nitrophenyloctylether and 2-fluoro-2 nitrodiphenyl ether, ethylene carbonate, propylene carbonate and N-alkyl-alkylamide (N-methylpropanamide, N-methylacetamide, N-methylformamide.

15. Electroactive polymer composition according to any one of the claims 12-14, wherein the concentration of the plasticizer(s) is in the range of 5 to 80 wt. %, preferably of 10 to 70 wt. % based on the total weight of the composition.

16. Electroactive polymer composition according to any one of the claims 12-15, comprising at least one polyurethane-(alkyl)acrylate copolymer, composed of at least one monomer selected from the group consisting of monomers represented by formula I and monomers represented by formula II 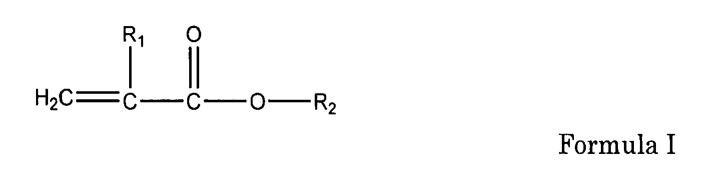 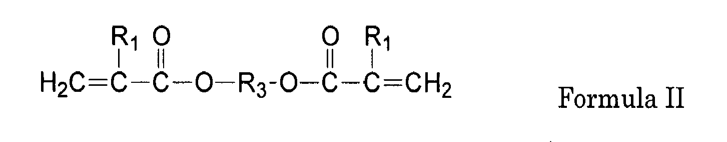 wherein each R₁ is independently selected from hydrogen, optionally substituted alkyls (in particular methyl) and polar moieties;
wherein R₂ is selected from polar moieties and aromatic moieties;
wherein R₃ comprises at least one aromatic moiety based on an aromatic diisocyanate, in particular on an aromatic diisocyanate selected from the group consisting of toluenediisocyanate (TDI) and methylene diphenyl isocyanate (MDI).

17. An electroactive polymer composition according to any one of the claims 12-16, comprising at least one additive selected from dielectric constant improving additives (such as carbon nano tubes, ceramic particles having a high dielectric constant) and organic polarisable compounds.

18. Electroactive polymer composition according to claim 17, wherein the organic polarisable compound is represented by the formula
P₁-Ar₁-U-Ar₂-P₂
wherein
P₁ is an electron donating moiety, preferably selected from the group consisting of -OH, -NH₂, -NROH -NHR, -NRR, -OR, -O(CO)R, -NH(CO)R, aryloxy , -phenyl, wherein each R represents the same or a different substituted or unsubstituted hydrocarbon group;
P₂ is an electron accepting moiety, preferably selected from the group consisting of -CN, -NO₂, -SO₃H, -CF₃, halogens, -COOH, -COOR, -(CO)R
wherein each R represents the same or a different substituted or unsubstituted hydrocarbon group;
Ar₁ and Ar₂ are aromatic moieties, preferably a moiety comprising an aromatic C-6 ring;
and U represents a moiety comprising a double bound, preferably a moiety comprising a C=C or N=N bond.

19. Article comprising an actuator according to any one of the claims 9-11.

20. Article according to claim 19, selected from the group consisting of parts for a motor vehicle (adjustable mirrors, pumps, injectors, windscreen wipers, seats), sports articles (skis, helmets, knee protectors, elbow protectors, shinbone protectors, protectors for other body parts), textiles, shoes, healthcare articles (rehabilitation articles, surgical devices, implantable valves, pacemakers, (guidable) catheters, supportive clothing, artificial muscles), microsystems (moveable parts in electronic equipment such as DVD/CD players, disk drives, microlocks, microswitches, cameras (focus, zoom), speakers, microphones, anti-vibration materials), pumps, valves, drives, antitheft tags, packings, gaskets, devices for inducing peristaltic movement.

21. Use of a polymer composition according to any one of the claims 12-18, or an actuator according to any one of the claims 9-11 to convert mechanical energy into electrical energy and/or to convert electrical energy into mechanical energy.

22. Use of a polymer composition according to any one of the claims 12-18, or an actuator according to any one of the claims 9-11 to make the roughness of a surface adjustable, in a massaging facility, to influence the aerodynamic behaviour of a surface, to make insulating properties of an article adjustable, to make the stretchability of an article adjustable or to improve support, comfort or a protective property of an article.
